(19) Europäisches Patentamt
European Patent Office
Office européen des brevets

(11) EP 1 978 641 A1

(12) EUROPEAN PATENT APPLICATION

(43) Date of publication:
08.10.2008 Bulletin 2008/41

(51) Int Cl.:
*H03K 17/95* (2006.01)      *H01F 5/02* (2006.01)

(21) Application number: 07360014.0

(22) Date of filing: 04.04.2007

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(71) Applicant: **SENSTRONIC, S.A.**
**F-67700 Saverne (FR)**

(72) Inventors:
• **Kirchdoerffer, Rémy**
**1134 Vufflens le château (CH)**
• **Frolov, Vladimir**
**67100 Strasbourg (FR)**

(74) Representative: **Nuss, Pierre et al**
**Cabinet Nuss**
**10, rue Jacques Kablé**
**67080 Strasbourg Cédex (FR)**

(54) **Method for compensation of temperature dependent variation of coil resistance and inductive proximity swich using said method**

(57) The present invention concerns a method for compensating the resistance variation of a multilayer coil depending on the temperature variation of said coil.

Method characterised in that it consists in determining at least one particular frequency or range of frequencies at which the dependency on the temperature of the ohmic resistance of the coil is less than or equal to a preset value, preferably at its lowest or minimum, and in feeding said coil, in use, at a frequency value equal to said at least one aforementioned particular frequency or situated within said at least one particular range of frequencies.

## Description

The invention relates in particular to the development of inductive proximity switches for detecting metal objects. Inductive switches are widely used in automatic control systems for mechanical and robotronic equipments.

The present invention concerns more specifically a method for compensation of temperature dependent variation of coil resistance and an inductive proximity or presence switch or sensor using said method.

The operating principle of inductive switches is based on an electric LC-oscillating circuit which generates a variable electromagnetic field of frequencies ranging from several tens to several hundreds kilohertz depending on the type of the switch. A metal object to be detected interacts with the oscillation circuit field changing its parameters, primarily the Q-factor. A change in the parameters of the oscillation circuit is acknowledged by the electronic circuit of the inductive switch.

One of the main problems encountered by inductive switch developers is strong dependence of oscillation circuit parameters on ambient temperature. This causes the reduction of switch sensing accuracy in the temperature range of use of -25 ˚C to 70 ˚C, as required by the international standards.

The physical mechanism of the variation of the Q-factor of the oscillation circuit as a function of the temperature, hence, variation of the switch sensing distance, is mainly the temperature dependency of the coil wire specific resistance.

For pure metals and continuous or direct current this dependence is approximately described by the formula:

$$R = R_0 (1 + k*T) \quad (1),$$

where $R_0$ is conductor resistance at temperature T=0.

The postulate of coil resistance strongly depending on temperature is the basic principle of patents and applications of the prior art temperature stabilization of inductive switches.

There are various known approaches to minimize the temperature influence on characteristics of inductive switch.

However, all known methods are instrumental, wherein temperature dependence of the oscillation circuit Q-factor is compensated either by providing additional compensating coils having the same temperature dependence of resistance as that of the switch operating coil, or by introducing special electronic circuits.

The following patents exemplify the existing approaches:

- US 2005/0184814 A1, Stefan Ehls, Jens Muller. "Inductive proximity switch with differential coil arrangement", August 25, 2005;
- US 6031430, Peter Heimlicher "Temperature stabilized oscillator and proximity switch containing the oscillator", February 29, 2000;
- US 5914593, Steven W. Arms, Christopher P. Townsend. "Temperature gradient compensated circuit", June 22, 1999;
- US 5072180, Jean-Michel Moreu. "Temperature compensated method and apparatus for detecting the oscillation of a resonant circuit to determine distance or proximity", December 10, 1991;
- US 4942372, Peter Heimlicher, "Method of circuit for reduction of temperature dependency in an oscillator", July 17, 1990;
- US 4509023, Peter Heimlicher, "Oscillator with a temperature compensated oscillating coil", April 2, 1985.

The disadvantages of these known compensation methods mainly reside in the complicated designs of the used coils (normally a temperature-compensated oscillation circuit is a multi-coil system) and the necessary additional electronic circuits, which result in high manufacturing costs and in a complex and cumbersome overall structure.

These disadvantages linked to the variation of resistance of a coil with temperature appear more widely in any device or circuit comprising or using such a coil.

It is a main aim of the present invention to overcome the aforementioned disadvantages.

Therefore, the main object of the present invention is a method for compensating the resistance value variation of a multilayer coil depending on the temperature variation of said coil, characterised in that it consists in determining at least one particular frequency or range of frequencies at which the dependency on the temperature of the ohmic resistance of the coil is less than or equal to a preset value, preferably at its lowest or minimum, and in feeding said coil, in use, at a frequency value equal to said at least one aforementioned particular frequency or situated within said at least one particular range of frequencies.

Claims 2 and 3 are directed to possible advantageous ways of determining the particular frequency or range of frequencies.

The invention also concerns a method for compensating the temperature drift of an inductive switch comprising a LC oscillation circuit with a multilayer inductive coil, preferably by eliminating the dependence of the circuit Q-factor on temperature, characterised in that it consists in determining at least one particular frequency or range of frequencies at which the dependency on the temperature of the ohmic resistance of the inductive coil is at its lowest or minimum, and in selecting the circuit inherent or natural oscillation frequency equal to said at least one particular frequency or within the at least one particular range of frequencies.

Claims 5 and 6 are directed to possible advantageous ways of determining the particular frequency or range of frequencies.

Finally, the invention encompasses further and inductive proximity or presence switch device, comprising a LC oscillation circuit with an inductive coil, characterised in that the inherent or natural oscillation frequency of the LC circuit is equal to a predetermined particular frequency or comprised within a predetermined particular range of frequencies at which the dependency on the temperature of the ohmic resistance of the coil is at its lowest or minimum, and in that said inductive coil is a multilayer coil made of a winding wire the diameter of which is greater in value or bigger than the depth of the skin layer for or at the inherent or natural oscillation frequency.

Claims 8 to 11 concern preferred embodiments of the switch device described before.

The invention will be better understood thanks to the following description and drawings of different embodiments of said invention given as non limitative examples thereof, wherein:

Fig. 1. illustrates the copper wire resistance-to-temperature relationship for various alternating current frequencies (the used wire is 0,22 mm in diameter and 18 m in length);

Fig. 2. illustrates the dependence of resistance (Fig. 2a) and temperature gradient (Fig. 2b) of copper wire on alternating current frequency (the used wire is 0,22 mm in diameter and 18 m in length);

Fig. 3. illustrates the copper wire and multilayer coil resistance-to-frequency relationships;

Fig. 4. illustrates the theoretical multilayer coil resistance-to-skin layer thickness relationships;

Fig. 5. is a diagrammatic representation of the multilayer coil resistance-to-alternating current frequency relationships at various temperatures;

Fig. 6. illustrates the resistance-to-frequency relationships of a multilayer ferriteless coil SPC-5 at various temperatures (the used wire is 0,2 mm in diameter and the number of coil turns is 40);

Fig. 7. illustrates the multilayer ferriteless coil SPC-5 resistance-to-temperature relationships at various temperatures (the wire is 0,2 mm in diameter and the number of coil turns is 40);

Fig. 8. illustrates the multilayer ferriteless coil SPC-5 Q-factor-to-temperature relationships at various frequencies (the used wire is 0,2 mm in diameter and the number of coil turns is 40);

Fig. 9. illustrates the Q-factor-to-temperature relationships of a multilayer ferriteless coil SPC-2 at various frequencies (the used wire is 0,16 mm in diameter and the number of coil turns is 85);

Fig. 10. illustrates resistance-to-temperature relationships of a the multilayer ferriteless coil SPC-6A at various frequencies (the used wire is 0,43 mm in diameter and the number of coil turns is 25);

Fig. 11. is a diagrammatic representation of the multilayer coil resistance temperature derivative-to-alternating current frequency relationship;

Fig. 12. illustrates the resistance-to-temperature relationships of a planar coil PLC-1at various frequencies (the used wire is 0,16 mm in diameter and the number of coil turns is 26);

Fig. 13. is a diagrammatic representation of a printed PCB-coil;

Fig. 14. illustrates the printed PCB-coil resistance-to-temperature relationship at various frequencies (coil shown on figure 13);

Fig. 15. illustrates the resistance-to-temperature relationships of a multilayer ferriteless coil SPC-7 at various frequencies (the used wire is 0,15 mm in diameter and the number of coil turns is 110), and

Fig. 16. illustrates the dependence of resistance of a multilayer coil SPC-7 with a ferrite core on temperature at various frequencies (the used wire is 0,15 mm in diameter and the number of coil turns is 110).

As mentioned before, the invention proposes to overcome the aforementioned disadvantages since it employs a special design coil with self-compensation of temperature dependence of coil effective resistance by selecting a specifically adapted natural oscillation frequency.

The basic idea of the invention is that the induction coil used in the oscillation circuit is a multilayer coil wound with wire of the diameter bigger than the depth of the skin layer for the selected frequency of the inherent circuit oscillations while the frequency of inherent circuit oscillations is so selected that at this frequency the ohmic resistance of the coil weakly depends on temperature.

The physical foundation for the present invention is the skin effect theory and A. Sommerfeld's theory of resistance of a multilayer coil for alternating current.

These two theories are briefly specified hereinafter.

The skin effect is a well known phenomenon of alternating current redistribution along conductor cross-section. As a result of the skin effect the effective cross section through which the current flows becomes less (than the material cross section) and conductor resistance increases in comparison with continuous current feeding.

The thickness of the skin layer (the effective cross section of an AC conductor) is described by the widely known expression:

$$\delta = \sqrt{\frac{2}{\varpi * \mu 0 * \sigma}} \qquad (2),$$

where $\mu 0$ (= $4\pi* 10^{-7}$) is the vacuum magnetic permeability, $\overline{\omega}$ is the circular frequency, $\sigma$ is the metal conductivity (copper conductivity is $5.8* 10^7$ at room temperature).

Using (2) it may be easily calculated that for a current with a frequency of 100 kHz, the skin layer thickness of copper wire is 0,2 mm, and for a current with a frequency of 1000 kHz, this thickness is 0,063 mm (at room temperature).

Formula (2) also shows, that in case of alternating current the temperature dependence of the conductor resistance becomes more complicated.

Indeed, as temperature rises, the metal conductivity $\sigma$ drops and, according to formula (2), the skin layer thickness, hence, the effective cross section through which the current flows, increases, thus partially compensating (slowing) temperature growth of the full conductor resistance R.

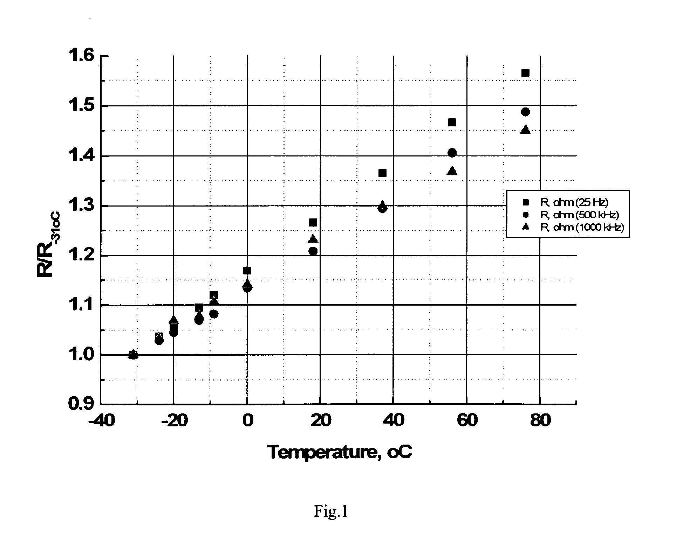

The inventors have observed the effect of variation of temperature dependence of insulated conductor resistance (in free space) on alternating current frequency for copper wire being 0,2 mm in diameter and 18 m long. These data are shown in Fig. 1.

One can see, that for the studied range of temperatures and frequencies the resistance-to-temperature relationship of free copper wire remains approximately linear, with temperature gradient slightly depending on the alternating current frequency:

$$R=R_0(\omega)\,[1+k(\omega)*T] \qquad (3)$$

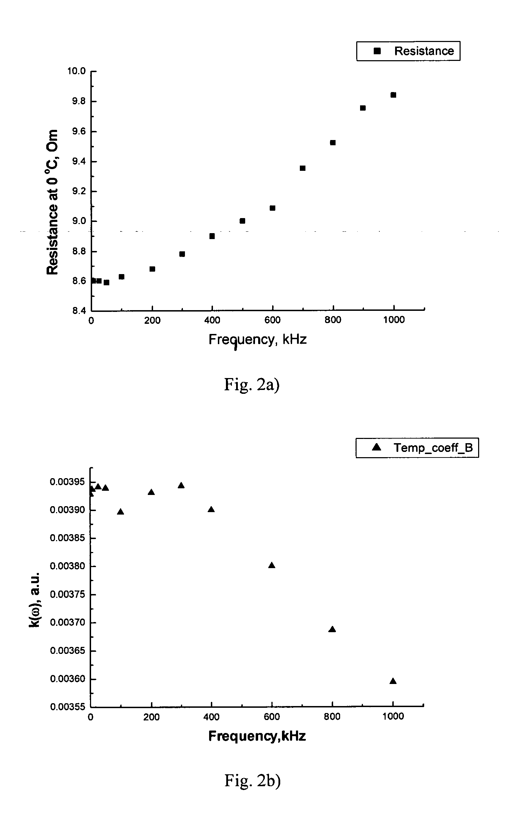

In a similar way to Fig.1, the dependency relationship between $R_0(\omega)$ and $k(\omega)$ for a free wire (0,22 mm in diameter) is shown in Fig. 2. Even for the smallest values of $k(\omega)$, the resistance changes are about 30-40% per 100 grad. temperature variation range.

The situation changes radically once we shift from the free wire to a multilayer coil wound with wire of the same diameter.

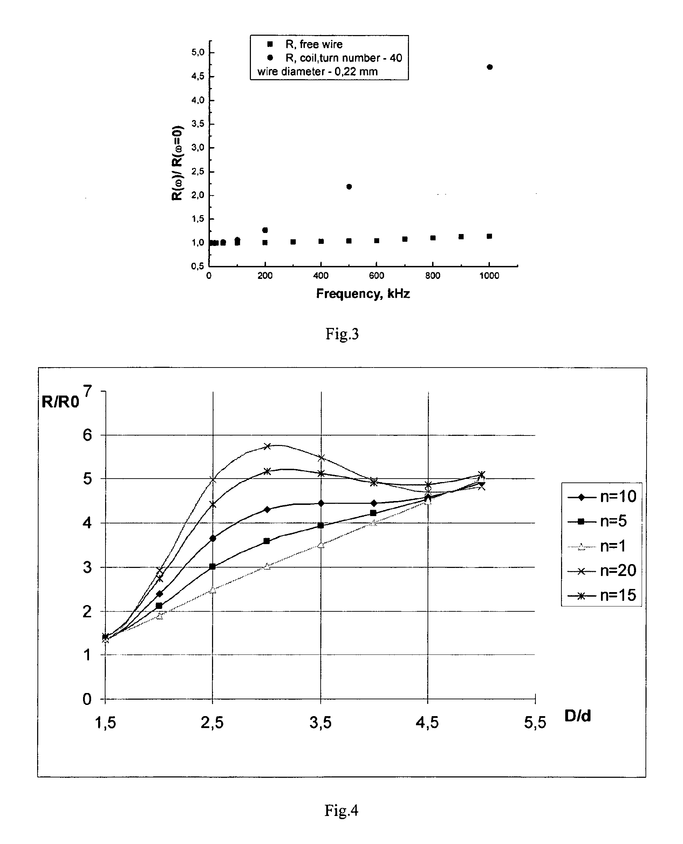

First of all, it is revealed in the dependence of ohmic resistance on frequency at ambient temperature (see Fig. 3).

As seen from the data illustrated on Fig. 3, the frequency dependence of resistance of one and the same wire is strongly dependent on wire winding topology.

Whereas for the free insulated (not wound) wire its resistance at 1000 kHz exceeds only by 30% that at continuous or direct current, the ratio of resistance values for alternating and constant currents for wound wire (coil) soars to 4,5 and more. This effect is explained by the fact that the distribution of current density in an isolated insulated wire and in closely adjacent wires differs considerably due to the intersection of magnetic fields of closely adjacent coil turns (this effect is known as magneto-resistivity).

Although the general theory behind this effect is fairly sophisticated, A. Sommerfeld obtained in the case of a long multilayer coil, an analytical solution for the dependence of multilayer coil resistance on skin layer thickness (Arnold Sommerfeld. Elektrodinamik., Akademische Verlagsgesellschaft Geets&Porting K.-G., 1949).

This dependence is described by the expression:

$$\frac{R}{R_0} = \frac{D}{d} \cdot \frac{\operatorname{sh} 2\frac{D}{dn} + \sin 2\frac{D}{dn} - \left(1 - \frac{1}{n}\right)\left(\operatorname{sh}\frac{D}{dn}\cos\frac{D}{dn} + \operatorname{ch}\frac{D}{dn}\sin\frac{D}{dn}\right)}{\operatorname{ch} 2\frac{D}{dn} - \cos 2\frac{D}{dn}}$$

$$(4)$$

where R is the active resistance of the coil, $R_0$ is the resistance for a constant current, D is the diameter of the coil wire, d is the skin layer depth and n is the number of layers of coil.

Various examples of the function [R/Ro vs. ratio D/d] are illustrated in Fig. 4.

As seen from Fig. 4, the dependence of inductive coil resistance on skin layer thickness, hence, on alternating current frequency (see formula (2)) largely depends on the number of layers of the winding and is a nonlinear function of the frequency.

Returning to Fig. 3, one can see that the dependency of coil resistance on frequency, which may not correspond to (3) any more, may be nevertheless for convenience subdivided into two parts, namely:

- $R_1$, "the low frequency part", which does practically not depend on the frequency, and
- $R_2$, "the high frequency part" characterised by the nonlinear dependency of resistance on frequency, defined by the coil topology.

Thus:

$$R = R_1(T) + R_2(T, \omega) \qquad (6)$$

Both $R_1$ and $R_2$ depend on temperature and in analysing these two different dependencies, the inventors came to the surprising conclusion that there is a frequency or range of frequencies within which temperature dependence of multilayer coil resistance, in presence of alternating current, is minimal, or even substantially non existing.

Hereinafter, this issue is being considered in greater details.

One notices that at a fixed frequency, an ambient temperature rise may bring about the following effects:

- firstly, the absolute value R of resistance at low frequencies will increase together with $R_1(T)$ due to copper conductivity/temperature relationship (see formula (1)),
- secondly, the range within which the resistance-to-frequency dependence is weak will widen towards high frequencies due to skin layer thickness growing with temperature,
- thirdly, the slope of the $R_2$ resistance-to-frequency nonlinear dependence in the range of high frequencies will decrease because the amount of current, hence, the interaction between the turns will decrease, due to resistance growing as temperature rises.

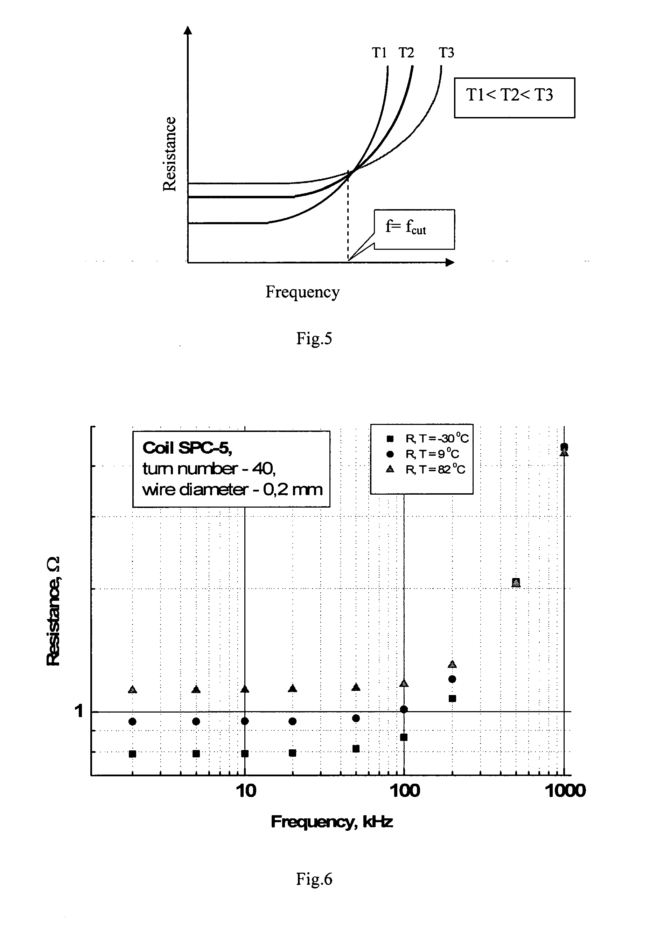

The said effects may result in the crossing of coil resistance-to-frequency relationships for various temperatures (shown diagrammatically in Fig. 5). If the zone of crossing points of these dependences is narrow enough, we can approximately mark it as a unique frequency $f_{cut}$.

One notices that in the range of frequencies $f \leq f_{cut}$ the coil resistance rises with temperature and that for the frequencies meeting the condition $f \geq f_{cut}$, the resistance decreases as temperature rises, while at $f = f_{cut}$ the changes of $R_1(T)$ are approximately compensated by the opposite changes of $R_2(T)$, so that the temperature dependence of the ohmic resistance R of the coil is weak, if not absent.

To practically verify the discovery of the existence of a frequency $f_{cut}$ at which ohmic resistance of a multilayer coil weakly depends on temperature and to provide a non limitative example of proposed invention embodiment, the inventors used a multilayer coil (CPS-5) without a ferrite core.

The used coil (CPS-5) had the following specifications:

- inner diameter of the coil: 4 mm;
- outer diameter of the coil: 12,5 mm;
- coil thickness: 0,7 mm;
- copper wire diameter: 0,2 mm;
- number of turns: 40.

The effective means of resistance of the coil at various alternating current frequencies was measured by means of an immitance meter of the E7-20 type. The coil under investigation was placed into a thermostatic Cold-Heat test chamber of the MK53 type (BINDER GmbH), which allowed for ambient temperature to vary from -30 ˚C to 80 ˚C.

The results of the measurements of coil resistance vs. frequencies (at different temperatures) are given in Fig. 6.

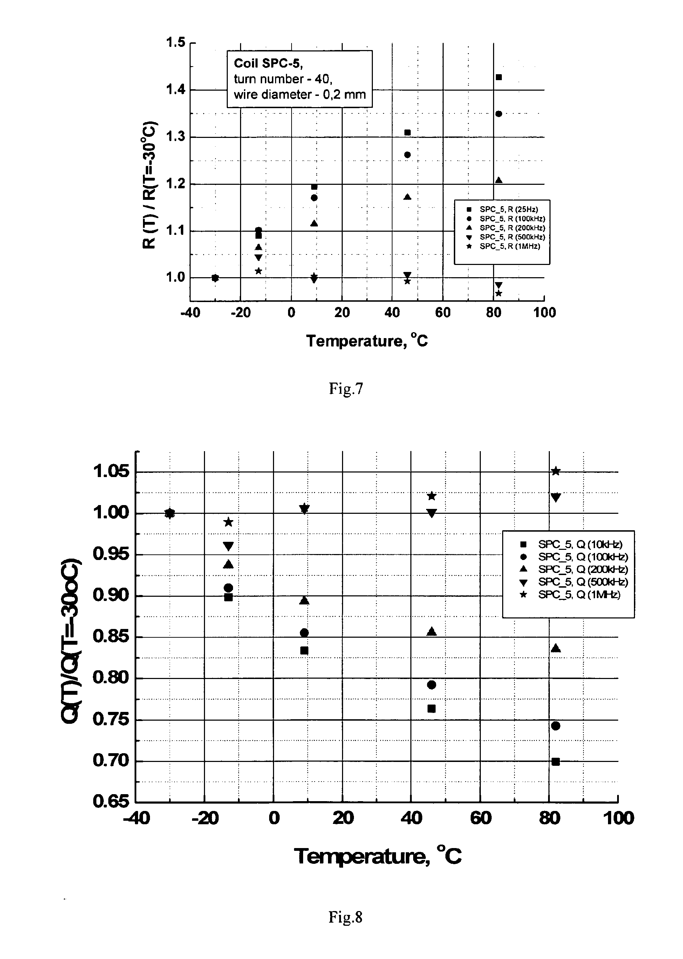

As seen from the illustrated experimental values, there is strong dependence upon frequency of the coil resistance variation with temperature with the resistance vs. temperature derivative $\partial R / \partial T$ changing its sign in the frequency range of 200 kHz to 500 kHz. A more vivid demonstration of the effect of the derivative changing its sign is presented in Fig. 7 which shows coil resistance vs. temperature variations for various frequencies.

As follows from the data given in Fig. 7, the resistance-to-temperature relationship of a multilayer coil may differ several times depending on the alternating current frequency.

For frequencies in the area of 500 kHz this dependence is actually non existing.

A determining parameter of the LC-circuit forming the core components of inductive proximity switches, is its Q-factor which is given by the following well-known formula:

$$Q = \frac{\varpi \times L}{R} \qquad (5)$$

where Q is the oscillation circuit q-factor, $\overline{\omega}$ is the inherent oscillations frequency, L is the inductance value and R is the effective resistance.

Experiments conducted by the inventors have shown that the variation of value *L* with temperature is insignificant and so the temperature dependence of the oscillation circuit Q-factor-*Q* is only dependent on the temperature behaviour of the effective resistance R. This conclusion is confirmed by the experimental results presented in Fig. 8.

It follows from the data given in Fig. 8 that the relative variations of Q-factor do not exceed 5% for 500 kHz in the range of temperatures from -30 ˚C to 80 ˚C, whereas for frequencies below 100 kHz these variations make up to 30%.

Since the variation with temperature of the oscillation circuit Q-factor is the main factor determining the temperature drift of the sensitivity of the inductive switches, the results presented are an experimental proof of the possibility to implement the suggested method for decreasing, if not completely zeroing, the temperature drift by selecting a frequency at which inductive coil resistance-to-temperature relationship is at its minimum, if not null.

The method proposed by the inventors for decreasing temperature dependence of the oscillation LC-circuit Q-factor has a general character and is applicable for inductive coils with a different number of turns wound and with copper wire of different diameter, as compared to the example considered above.

Another example of embodiment relates to a multilayer coil without a ferrite core (coil SPC-2) and with the following parameters:

- inner diameter of coil: 4 mm;
- outer diameter of coil: 14 mm;
- coil thickness: 0,7 mm;
- copper wire diameter: 0,16 mm;
- number of turns: 85.

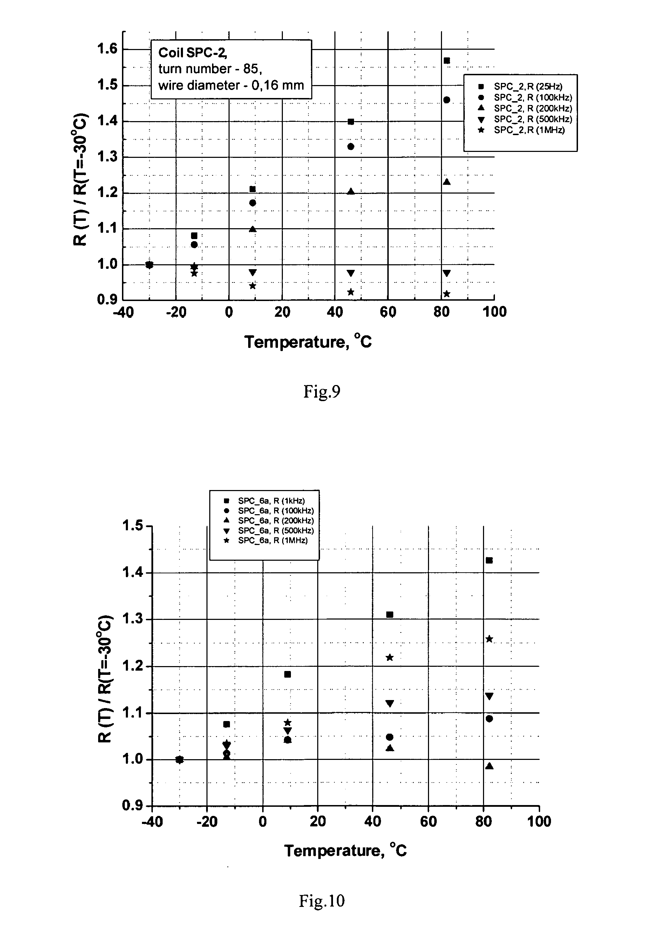

The results of [coil resistance vs. frequencies and temperatures] measurements for the above coil are given in Fig. 9. As can be seen from this figure, coil resistance varies by no more than 1 % for 500 kHz frequency in the temperature range from -30 ˚C to 80 ˚C.

The comparison of the data given in Fig. 6 and Fig. 9 shows that the effective resistance dependencies of the considered coils SPC-2 and SPC-5 on frequency are alike, notwithstanding the different number of coil turns and different resistance with constant current for both coils, this difference being approximately of 100%.

For coils wound with a thicker wire, a more complicated dependency of coil resistance on frequency is observed.

To demonstrate this statement, further data have been collected for a coil SPC-6A with the following parameters:

- inner diameter of coil: 4 mm;
- outer diameter of coil: 13,5mm;
- coil thickness: 1,5 mm;
- copper wire diameter: 0,43 mm;
- number of turns: 25.

The results of [coil resistance vs. frequency and temperature] measurements for the SPC-6A coil are given in Fig. 10.

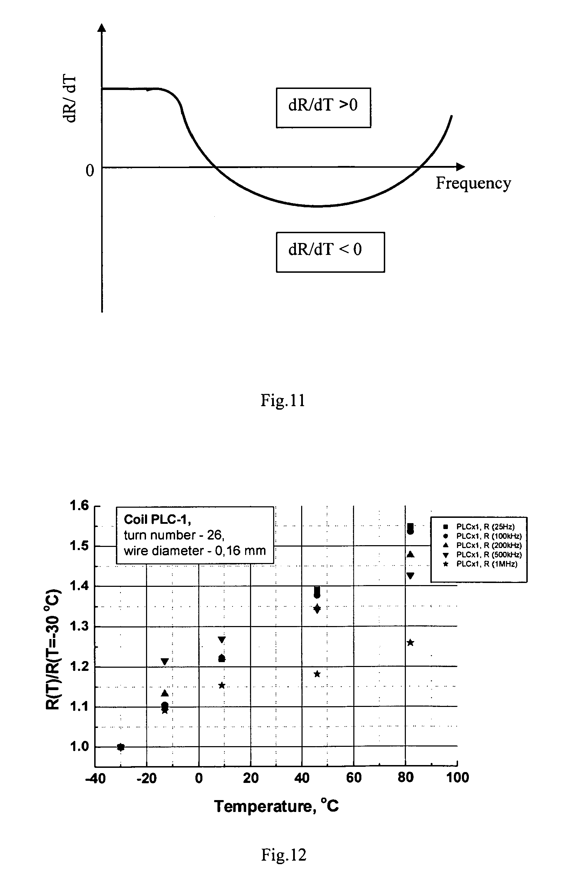

The study of the data given in Fig. 10 leads to the conclusion that for the SPC-6A coil there are not one, but two frequencies at which resistance-to-temperature relationship changes sign. This effect is shown as a diagram in Fig. 11.

It is important to underline that the possibility of substantial compensation of temperature dependence by way of alternating current frequency selection is only feasible with multilayer coils. This was experimentally confirmed by the results of experiments with flat (planar) coils manufactured by the inventors using various technologies.

The first result concerns a single-layer planar coil made in the form of a spiral (coil PLC-1) with constructive parameters as follows:

- inner diameter of coil: 4 mm;
- outer diameter of coil: 13 mm:
- coil thickness: 0,16 mm:
- copper wire diameter: 0,16 mm:
- number of turns: 26.

The results of [coil resistance vs. frequency and temperature] measurements for coil PLC-1 are given in Fig. 12.

Comparing the data given in Fig. 12 with the data for the multilayer coil SPC-2 (Fig. 9) wound with a wire of the same diameter, allows to conclude that in the case of a single-layer (planar) coil the [resistance temperature-to-frequency] relationship is considerably lower.

In the case of the single-layer coil, the condition of complete temperature compensation is not attained within the entire range of frequencies used up to 1000 kHz. This could presumably be attributed to the turn-to-turn interaction of currents which in a single-layer coil is substantially less than in a multilayer one. Qualitatively this conclusion is in accordance with A.Sommerfeld's theory (formula 4, Fig. 4).

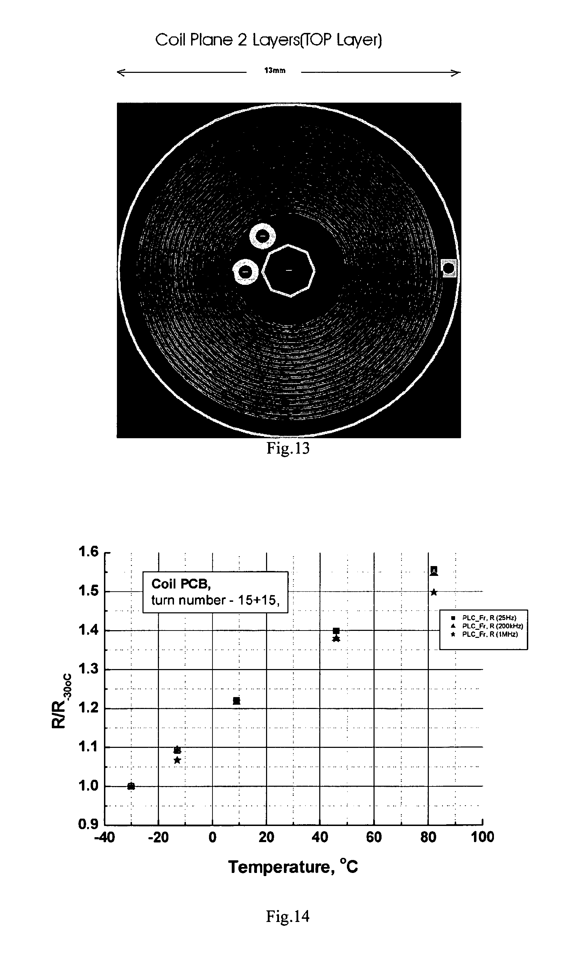

The turn-to-turn interaction can be even further decreased by using the planar coils made for example by lithography method. An example of such coil is shown in Fig. 13.

The PCB-coil whose design is given in Fig. 13 is made by the method of lithography of foil laminated micarta. The path ('wire') width is 100 microns, the distance between the paths is 150 microns and the number of turns is 15+15. The PCB-coil differs mainly from the planar coil PLC-1 by a greater turn-to-turn distance, which should cause depletion of turn-to-turn interaction of currents.

The conclusion made is confirmed by the results obtained by measuring the resistance of PCB-coil vs. frequency and temperature. These data are given in Fig. 14.

As follows from the data given in Fig. 14, with respect to planar coils with clearance between the turns, the temperature dependence of resistance only slightly varies with frequency in the range from Hz to MHz, which means that it is close to the temperature dependence of resistance for constant current. In other words, to substantially change the temperature dependence of inductive coil resistance, one should use multilayer coils and a specific frequency fulfilling this condition.

It should be noted that most inductive switches use coils with ferrite cores, which help to improve oscillation circuit Q-factor, hence to raise inductive switch sensitivity.

In this context, the applicability of the temperature compensation method suggested by the inventors for coils with ferrite cores becomes indeed essential.

A multilayer coil SPC-7 with the parameters shown below was selected as a non limiting example of embodiment of the inventive method:

- inner diameter of coil: 7 mm;
- outer diameter of coil: 11 mm;
- coil thickness: 2 mm;
- copper wire diameter: 0,15 mm;
- number of turns: 110.

First, the inventors measured the dependency of the resistance on frequency and on temperature for said coil without any ferrite.

Then the coil was placed into a standard ferrite 'sleeve' and the same dependencies were studied again.

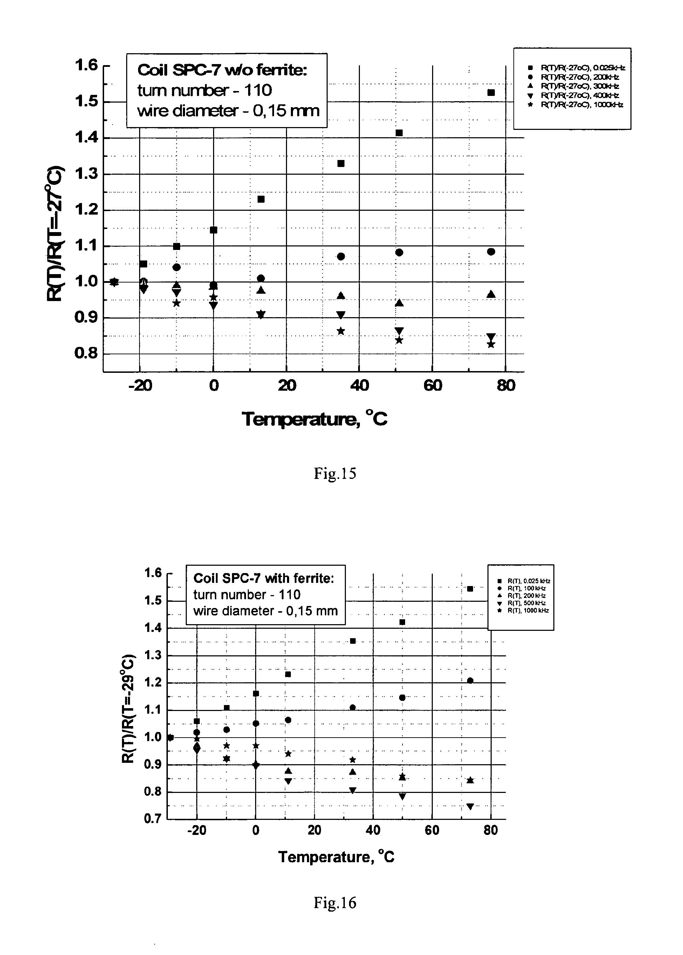

The results of the [resistance vs. frequency and temperature] measurements of the free coil SPC-7 are given in Fig. 15.

One can see, that the resistance-to-temperature relationship of the coil changes its sign in the frequency range of 200 kHz to 300 kHz and the value of the resistance derivative with respect to temperature is minimal in said range of frequencies.

Another example of an embodiment of the invention of great practical importance is the results of investigations concerning the coil SPC-7 placed in a ferrite 'sleeve'.

These results are given in Fig. 16 and their analysis shows that the [resistance-to-frequency and temperature] relationships of the coil placed in the ferrite 'sleeve' are similar to the relationships of a 'ferritless' coil (see Fig. 15). The difference lies in the values of the limits of the frequency range. Indeed, for the coil with a ferrite core the range of frequencies where the derivative of resistance-to-temperature relationship is minimal between 100 and 200 kHz, whereas for the coil without a ferrite core this frequency range with minimal derivative is within 200 to 300 kHz.

Depending, among other parameters, on the layout of the coil, the particular frequency, at which the temperature dependency of the coil resistance is at ist lowest, can either be practically unique, or belong to a limited range of frequencies.

Even though, the invention has been described more particularly in relation to inductive presence or proximity switches or sensors, it should be noted that the inventive method features described herein can be applied in any device, system or apparatus using a multilayer coil which can be fed by an ajustable frequency signal, in order to compensate the temperature related variation of the coil resistance.

The present invention is of course not limited to the preferred embodiments described and represented herein, changes can be made or equivalents used without departing from the scope of the invention.

## Claims

1.  Method for compensating the resistance variation of a multilayer coil depending on the temperature variation of said coil, **characterised in that** it consists in determining at least one particular frequency or range of frequencies at which the dependency on the temperature of the ohmic resistance of the coil is less than or equal to a preset value, preferably at its lowest or minimum, and in feeding said coil, in use, at a frequency value equal to said at least one aforementioned particular frequency or situated within said at least one particular range of frequencies.

2.  Method according to claim 1, **characterised in that** the determination of said at least one particular frequency or range of frequencies consists in determining the dependency functions on the frequency of the ohmic resistance of the coil at at least two different temperatures, finding out the common or mutual crossing point(s) or part(s) of these functions and determining the particular frequency or range of frequencies corresponding to said point(s) or part(s).

3.  Method according to claim 1, **characterised in that** the determination of said at least one particular frequency or range of frequencies consists in performing a plurality of [coil resistance vs. frequency] measurements at at least two different temperatures, in representing the collected data on an adapted diagram, in detecting the crossing points or area of the at least two resulting graphs and in determining the corresponding particular frequency or range of frequencies.

4.  Method for compensating the temperature drift of an inductive switch comprising a LC oscillation circuit with a multilayer inductive coil L, preferably by eliminating the dependence of the circuit Q-factor on temperature, **characterised in that** it consists in determining at least one particular frequency or range of frequencies at which the dependency on the temperature of the ohmic resistance of the inductive coil is at its lowest or minimum, and in selecting the circuit inherent or natural oscillation frequency equal to said at least one particular frequency or within the at least one particular range of frequencies.

5.  Method according to claim 4, **characterised in that** the determination of said at least one particular frequency or range of frequencies consists in determining the dependency functions on the frequency of the ohmic resistance of the coil at at least two different temperatures, finding out the common or mutual crossing points or parts of these functions and determining the corresponding particular frequency or range of frequencies corresponding to said point(s) or part(s).

6.  Method according to claim 4, **characterised in that** the determination of said at least one particular frequency or range of frequencies consists in performing a plurality of [coil resistance vs. frequency] measurements at at least two different temperatures, in representing the collected data on an adapted diagram, in detecting the crossing points or area of the at least two resulting graphs and in determining the corresponding particular frequency or range of frequencies.

7.  Inductive proximity or presence switch device, comprising a LC oscillation circuit with an inductive coil L, **characterised in that** the inherent or natural oscillation frequency of the LC circuit is equal to a predetermined particular frequency or comprised within a predetermined particular range of frequencies at which the dependency on the temperature of the ohmic resistance of the coil is at its lowest or minimum, and **in that** said inductive coil is a multilayer coil made of a winding wire the diameter of which is greater than the depth of the skin layer at the inherent or natural oscillation frequency.

8.  Inductive switch device according to claim 7, **characterised in that** the inductive coil is a multilayer coil without a ferrite core, made of 20 to 200 turns of copper wire having a diameter between 0,1 and 1,0 mm and **in that** the frequency of inherent or natural oscillation of the LC-circuit is within the range of 50 kHz to 2 MHz.

9. Inductive switch device according to claim 8, **characterised in that** the inductive coil is selected among the following group of possible coils:

> - a coil with 85 turns wound with copper wire of 0,16 mm diameter, the frequency of inherent circuit oscillations being within the range of 450 kHz to 550 kHz;
> - a coil with 40 turns wound with copper wire of 0,2 mm diameter, the frequency of inherent circuit oscillations being within the range of 450 kHz to 550 kHz;
> - a coil with 85 turns wound with copper wire of 0,16 mm diameter, the frequency of inherent circuit oscillations being within the range of 200 kHz to 500 kHz;
> - a coil with 25 turns wound with copper wire of 0,43 mm diameter, the frequency of inherent circuit oscillations being within the range of 100 kHz to 200 kHz;
> - a coil with 110 turns wound with copper wire of 0,15 mm diameter, the frequency of inherent circuit oscillations being within the range of 200 kHz to 300 kHz.

10. Inductive switch device according to claim 7, **characterised in that** the inductive coil is a multilayer coil with a ferrite core, made of 20 to 200 turns of copper wire having a diameter between 0,1 and 1,0 mm and **in that** the frequency of inherent or natural oscillation of the LC-circuit is within the range of 50 kHz to 2 MHz.

11. Inductive switch device according to claim 10, **characterised in that** the inductive coil is a coil with 110 turns wound with copper wire of 0,15 mm diameter, the frequency of inherent circuit oscillations being within the range of 100 kHz to 200 kHz.

Fig.1

Fig. 2a)

Fig. 2b)

Fig.3

Fig.4

Fig.5

Fig.6

Fig.7

Fig.8

Fig.9

Fig.10

Fig.11

Fig.12

Coil Plane 2 Layers(TOP Layer)

Fig.13

Fig.14

Fig.15

Fig.16

**European Patent Office**

**EUROPEAN SEARCH REPORT**

Application Number

EP 07 36 0014

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DE 26 18 163 A1 (HISS ECKART) 17 November 1977 (1977-11-17) * page 4, line 19 - page 5, line 32 * ----- | 1-11 | INV. H03K17/95 H01F5/02 |
| X | DE 196 35 298 A1 (SCHENCK PROCESS GMBH [DE]) 5 March 1998 (1998-03-05) * column 1, lines 38-47 * ----- | 1-11 | |
| X | EP 1 376 064 A (FESTO AG & CO [DE]) 2 January 2004 (2004-01-02) * paragraph [0033] * ----- | 1-11 | |
| X | DE 15 89 826 A1 (GRIESE ALFONS; LUZ DIPL ING HANS) 21 May 1970 (1970-05-21) * page 13, lines 1-22 * ----- | 1-11 | |
| X | DE 39 31 892 A1 (KLASCHKA IND ELEKTRONIK [DE] KLASCHKA GMBH & CO [DE]) 4 April 1991 (1991-04-04) * column 3, lines 24-32; figure 1 * * column 5, line 62 - column 6, line 1 * * column 1, lines 15-20 * ----- | 1-11 | TECHNICAL FIELDS SEARCHED (IPC) H03K H01F |

The present search report has been drawn up for all claims

| Place of search | Date of completion of the search | Examiner |
|---|---|---|
| Munich | 20 July 2007 | Moll, Peter |

EPO FORM 1503 03.82 (P04C01)

**ANNEX TO THE EUROPEAN SEARCH REPORT
ON EUROPEAN PATENT APPLICATION NO.**

EP 07 36 0014

This annex lists the patent family members relating to the patent documents cited in the above-mentioned European search report.
The members are as contained in the European Patent Office EDP file on
The European Patent Office is in no way liable for these particulars which are merely given for the purpose of information.

20-07-2007

| Patent document cited in search report | | | Publication date | Patent family member(s) | | Publication date |
|---|---|---|---|---|---|---|
| DE 2618163 | A1 | | 17-11-1977 | NONE | | |
| DE 19635298 | A1 | | 05-03-1998 | NONE | | |
| EP 1376064 | A | | 02-01-2004 | DE 10227019 A1 | | 08-01-2004 |
| DE 1589826 | A1 | | 21-05-1970 | NONE | | |
| DE 3931892 | A1 | | 04-04-1991 | NONE | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20050184814 A1, Stefan Ehls, Jens Muller
- US 6031430 A, Peter Heimlicher
- US 5914593 A, Steven W. Arms, Christopher P. Townsend
- US 5072180 A, Jean-Michel Moreu
- US 4942372 A, Peter Heimlicher
- US 4509023 A, Peter Heimlicher